# EUROPÄISCHE PATENTSCHRIFT

(11) **EP 2 287 666 B1**
(45) Veröffentlichungstag und Bekanntmachung des Hinweises auf die Patenterteilung: **27.06.2012**
(21) Anmeldenummer: 09010779.8
(22) Anmeldetag: 22.08.2009
(51) Int. Cl.: G03F 7/00

(54) **Vorrichtung zum Prägen von Substraten**
Device for embossing substrates
Dispositif de gaufrage de substrats

(43) Veröffentlichungstag der Anmeldung: 23.02.2011
(73) Patentinhaber: EV Group E. Thallner GmbH, 4782 St. Florian (AT)
(72) Erfinder: Lindner, Friedrich Paul, 4780 Schärding (AT); Glinsner, Thomas, 4782 St. Florian am Inn (AT); Wimplinger, Markus, 4910 Ried im Innkreis (AT)
(74) Vertreter: Schweiger, Johannes

(56) Entgegenhaltungen:
- WO-A-2007/067469
- WO-A-2007/123805
- US-A1- 2005 064 054
- US-A1- 2007 063 384
- US-A1- 2007 065 532
- US-A1- 2007 077 325

## Beschreibung

Die vorliegende Erfindung betrifft eine Vorrichtung gemäß Patentanspruch 1 sowie ein Verfahren gemäß Patentanspruch 12.

Prägeverfahren wie beispielsweise Heißprägen von Polymersubstraten, spin-on Oligo- oder Polymeren oder UV-basierende Nanoimprintverfahren sind als "single step" oder "step & repeat"-Verfahren bekannt, wobei sich die step-and-repeat-Verfahren zur Herstellung von großen Substraten, beispielsweise 300 mm-Siliziumwafer, eignen, die in vielen Einzelschritten geprägt werden. Dabei werden beispielsweise kleine, kostengünstigere strukturierte Quarzglasstempel mit aktiven Flächen von beispielsweise 25 mm x 25 mm mit sehr hohen Auflösungen < 10 nm und Justiergenauigkeiten < 50 nm zwischen Stempel und Substrat erreicht.

Die WO 2007/123805 A2 betrifft ein Nanolithographieprägesystem. Die US 2007/0065532 A1 betrifft ein System zur Steuerung einer Atmosphäre zwischen einem Körper und einem Substrat. Die US 2007/0077325 A1 betrifft eine Vorrichtung zum Heißprägen. Die US 2005/0064054 betrifft eine Musterausbildungsvorrichtung.

Bekannte Prägeverfahren zur Erzeugung von Strukturgrößen in nm- und µm-Bereich weisen häufig das Problem von Gaseinschlüssen im Fotolack auf, die einerseits von einer geschlossenen Umgebungsluft zwischen Stempel und Substrat herrühren können, andererseits aber auch durch aus dem Lack entweichendes Lösungsmittel entstanden sein können.

Der Erfindung liegt daher die Aufgabe zu Grunde, ein Verfahren sowie eine Vorrichtung anzugeben, mit der möglichst fehlerfreie Strukturen auf Substrate aufgebracht werden können, auch bei sehr hohen Auflösungen im Nanometerbereich.

Diese Aufgabe wird mit den Merkmalen der Anspruche 1 und 12 gelöst. Vorteilhafte Weiterbildungen der Erfindung sind in den Unteransprüchen angegeben. In den Rahmen der Erfindung fallen auch sämtliche Kombinationen aus zumindest zwei der in der Beschreibung, den Ansprüchen und/oder den Zeichnungen angegebenen Merkmale.

Der Erfindung liegt der Gedanke zu Grunde, eine definierte Atmosphäre beim entscheidenden Schritt des Prägens der Strukturen in das auf dem Substrat befindliche Strukturmaterial einzustellen, wobei die definierte Atmosphäre sich von der die Vorrichtung umgebenden Atmosphäre, insbesondere hinsichtlich des Gasdrucks, unterscheidet. Insofern sind innerhalb der Vorrichtung Mittel zur Einstellung einer solchen definierten Atmosphäre vorgesehen.

Weiterhin kann die definierte Atmosphäre einen bestimmten, insbesondere von der Umgebung unterschiedlichen, Druck umfassen, vorzugsweise durch Mittel zur Ein- und/oder Verstellung des Drucks. Bevorzugt erfolgt das Kontaktieren bei einem vorgegebenen Druck p₁, während das Füllen des Stempels bei einem vorgegebenen Druck p₂ erfolgt. Dabei ist p₁ mit Vorteil kleiner als p₂.

Die Mittel können beispielsweise geeignet sein, bestimmte Fluide und/oder Verunreinigungen aus einem die Prägeeinrichtung zumindest teilweise aufnehmenden Arbeitsraum zumindest größtenteils abzuziehen oder zu eliminieren beziehungsweise in einem von der Prägeeinrichtung abgetrennten Bereich des Arbeitsraums anzureichern.

Durch die vorgenannten Maßnahmen werden Einschlüsse von Fremdmaterial im Strukturmaterial deutlich reduziert beziehungsweise vollständig ausgeschlossen.

In einer vorteilhaften Ausgestaltung der erfindungsgemäßen Vorrichtung ist die definierte Atmosphäre durch einen Gasdruck kleiner dem Gasdruck außerhalb des Arbeitsraumes definiert. Noch vorteilhafter ist die definierte Atmosphäre praktisch frei von Gasen beziehungsweise mit einer sehr geringen Gaskonzentration im Vergleich zur den Arbeitsraum umgebenden Atmosphäre versehen, wobei noch bevorzugter keine Umgebungsluft im Arbeitsraum vorhanden ist. Dies kann beispielsweise in Form eines Vakuums mit einem Druck < 300 mbar erreicht werden, wobei auch ein vorheriges Ausspülen von Umgebungsluft aus dem Arbeitsraum mit anderen Gasen in den Rahmen der Erfindung fällt. Besonders bevorzugt weist die definierte Atmosphäre einen 02-Gehalt <3 %, insbesondere <1 %, noch bevorzugter <0,5 % auf. Im Idealfall herrscht eine 02-freie Atmosphäre im Arbeitsraum.

Dabei ist es weiterhin von Vorteil, wenn der Arbeitsraum über eine den Arbeitsraum mit einer Vakuumeinrichtung verbindende Vakuumleitung mittels der Vakuumeinrichtung mit einem Vakuum als definierte Atmosphäre beaufschlagbar ist.

Wird die Vorrichtung als step & repeat-Vorrichtung zur Prägung des Substrats in mehreren Prägeschritten innerhalb des Prägevorgangs ausgebildet, können sehr große Substrate bei Einsatz von kleinen, kostengünstigen Prägestempeln eingesetzt werden. Die Prägestempel weisen die auf das Substrat zu prägenden Prägestrukturen auf, wobei zur Miniaturisierung der Strukturen entsprechende Prägestrukturen als Nanostrukturen oder kleiner als Nanostrukturen ausgebildet sind. Hieraus ergibt sich die Konsequenz, dass die in der Vorrichtung enthaltenen Bauteile und weitere Einrichtungen, insbesondere eine Justiereinrichtung entsprechend den vorgesehenen Nanostrukturen genau arbeiten müssen. Auch hierbei wirkt sich die definierte Atmosphäre positiv auf die genannten Einrichtungen aus.

Indem die Vorrichtung eine zumindest teilweise im Arbeitsraum angeordnete, Aufbringeinrichtung zur Aufbringung von Strukturmaterial auf das Substrat in einem Aufbringvorgang aufweist, lassen sich die vorgenannten Vorteile und Ausgestaltungen auch auf den Aufbringvorgang übertragen.

So ist es beispielsweise von Vorteil, wenn der Aufbringvorgang in mehrere Aufbringschritte zur Aufbringung des Strukturmaterials auf Flächenabschnitte des Substrats unterteilt ist.

Weiterhin ist in einer vorteilhaften Ausgestaltung der Erfindung vorgesehen, dass die Aufbringeinrichtung Düsen zur Aufbringung des Strukturmaterials in Tropfenform aufweist. Alternativ hierzu kann die Aufbringeinrichtung Mittel zur Aufbringung des Strukturmaterials im Spinverfahren oder Siebdruckverfahren oder Sprühverfahren oder Piezoverfahren aufweisen.

Indem auch der Aufbringvorgang in der oben beschriebenen definierten Atmosphäre durchführbar ist, können etwaige, beim Aufbringen des Strukturmaterials entstehende Gaseinschlüsse oder durch Ausdampfen von im Strukturmaterial vorhandenen Lösungsmitteln entstehende Gaseinschlüsse weitgehend vermieden beziehungsweise vollständig ausgeschlossen werden.

Besonders vorteilhaft ist eine Ausgestaltung der Erfindung, bei der der Aufbringvorgang so steuerbar ist, dass Strukturmaterial nur in mit Kavitäten des Prägestempels korrespondierenden Strukturbereichen in definierten Strukturmaterialeinheiten aufgebracht wird. Durch diese Maßnahme können einerseits erhebliche Mengen Strukturmaterial eingespart werden und andererseits kann die sich ergebende Gesamtdicke der auf das Substrat aufgebrachten Strukturen minimiert werden. Hierdurch wird darüber hinaus die Verarbeitungszeit, insbesondere bei dem auf den Prägevorgang folgenden Aushärtungsvorgang und Ätzvorgang, minimiert. Darüber hinaus führt diese Maßnahme zu einer gleichmäßigen Restschichtdicke. In diesem Fall ist es besonders vorteilhaft, im Vakuum zu prägen, um die Gefahr von Gaseinschlüssen besonders bei dieser Ausführung zu minimieren.

Hierbei ist es besonders vorteilhaft, wenn die Strukturmaterialeinheiten ein geringfügig größeres, insbesondere ein um bis zu 10 %, vorzugsweise bis zu 5 % größeres Volumen als die korrespondierenden Kavitäten des Prägestempels aufweisen, da dann bei Verdrängen der Strukturmaterialeinheiten durch die Kavitäten beim Prägevorgang entsprechend überschüssiges Strukturmaterial als geschlossene Zwischenschicht zwischen den erhabenen Strukturen eine Verbindung zwischen den benachbarten erhabenen Strukturen ausbildet.

Das erfindungsgemäße Verfahren zum Prägen von Substraten, insbesondere Halbleitersubstraten oder Wafern, weist in der allgemeinsten Ausführungsform gemäß Anspruch 12 folgende Schritte auf:
a) Justierung des Substrats mittels einer Justiereinrichtung gegenüber einer Aufbringeinrichtung zur Aufbringung von Strukturmaterial auf das Substrat in einem Aufbringvorgang,
b) Aufbringung des Strukturmaterials oder von Strukturmaterialeinheiten des Strukturmaterials auf das Substrat mittels der zumindest teilweise in Arbeitstraum (13) angeordneten Aufbringeinrichtung,
c) Justierung des Substrats mittels einer zumindest teilweise im Arbeitsraum angeordneten Justiereinrichtung gegenüber einer zumindest teilweise im Arbeitsraum angeordneten Prägeeinrichtung zum Prägen des Strukturmaterials auf das Substrat in einem Prägevorgang und
d) Prägen des Substrats durch die Prägeeinrichtung, wobei der Arbeitsraum vor und während des Prägevorgangs, insbesondere ununterbrochen mit einer definierten Atmosphäre beaufschlagbar ist.

Der Justiervorgang gemäß Schritt a) kann im Arbeitsraum, insbesondere mit der Justiereinrichtung gemäß Schritt c), durchgeführt werden. Dabei ist es von Vorteil, wenn die Aufbringung des Strukturmaterials in einer definierten Atmosphäre, analog der oben beschriebenen definierten Atmosphäre, insbesondere mit variablem Druck, erfolgt.

Die Aufbringung des Strukturmaterials erfolgt mit Vorteil von einem oberen Abschnitt des Arbeitsraums aus auf das unterhalb angeordnete Substrat.

Auch die Prägeeinrichtung ist mit Vorteil in dem oberen Abschnitt des Arbeitsraums angeordnet und der Prägestempel ist in vorteilhafter Ausgestaltung der Erfindung parallel verschieblich zu einem Aufbringelement der Aufbringeinrichtung angeordnet.

Das Bewegen des Prägestempels und/oder des Aufbringelements wird mit Vorteil von außerhalb des Arbeitsraums bewirkt.

Weitere Vorteile und zweckmäßige Ausführungen der Erfindung sind in den weiteren Ansprüchen, den Figuren, der Beschreibung und den Zeichnungen wiedergegeben.
- Fig. 1: zeigt eine schematische Seitenansicht einer Ausführungsform der erfindungsgemäßen Vorrichtung,
- Fig. 2: zeigt eine schematische Ansicht des Substrats und Strukturmaterials und des erfindungsgemäßen Prägestempels kurz vor dem Prägen,
- Fig. 3: zeit eine schematische Ansicht des Substrats und Strukturmaterials und des erfindungsgemäßen Prägestempels beim Prägen und
- Fig. 4: zeigt ein erfindungsgemäß geprägtes Substrat nach einem Prägeschritt und nach dem Aushärtevorgang.

In den Figuren sind gleiche Bauteile oder Bauteile mit gleicher Funktion mit identischen Bezugszeichen gekennzeichnet.

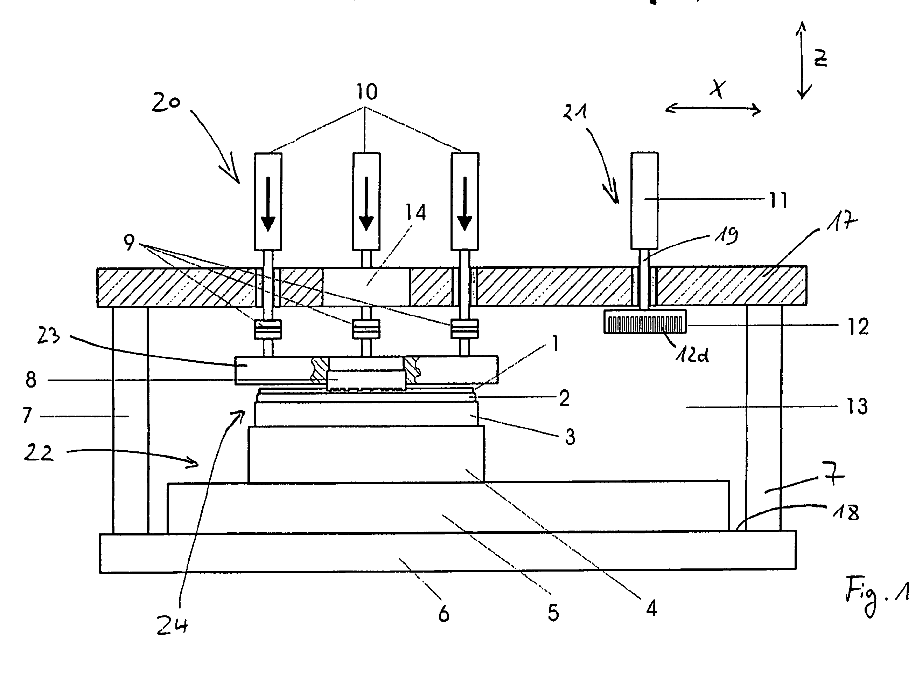

Figur 1 zeigt die erfindungsgemäße Vorrichtung in einer Ausführungsform mit einem Arbeitsraum 13, der von Seitenwänden 7, einem Deckel 17 und einer Grundplatte 6 begrenzt ist.

Auf der Grundplatte 6 ist eine Justiergrundplatte 5 angeordnet, die sich im Wesentlichen über den gesamten Boden 18 des Arbeitsraumes 13 erstreckt.

Auf der Justiergrundplatte 5 ist ein Justiertisch 4, insbesondere in einer X-Richtung geführt, verfahrbar angeordnet, um einen auf dem Justiertisch 4 angeordneten, insbesondere fixierten, Substrathalter 3 innerhalb des Arbeitsraumes 13 zu verfahren, insbesondere zu einer Prägeeinrichtung 20 und einer Aufbringeinrichtung 21. Der Substrathalter 3 ist Bestandteil einer Aufnahmeeinrichtung 24.

Die Justiergrundplatte 5 und der Justiertisch 4 sind Bestandteil einer Justiereinrichtung 22, die für den oben beschriebenen Bewegungsablauf zuständig ist. Weiterhin ist die Justiereinrichtung 22, insbesondere der Justiertisch 4, dafür vorgesehen, den Substrathalter 3 mit einem darauf angeordneten Substrat 2 gegenüber der Aufbringeinrichtung 21 genau zu justieren und auszurichten, nämlich in der in Figur 1 dargestellten X-Richtung und in die Zeichnungsebene von Figur 1 gerichtete Y-Richtung sowie in Rotationsrichtung in der durch X- und Y-Richtung aufgespannten Ebene E. Dabei wird der Positionier- und Justiervorgang von einer nicht dargestellten Steuereinrichtung gesteuert, wobei die genaue Ausrichtung anhand von nicht dargestellten Passmarken auf dem Substrat 2 und/oder dem Substrathalter 3 erfolgen kann.

Die Positionierung und Justierung von Düsen 12d eines Düsenkörpers 12 der Aufbringeinrichtung 21 in Z-Richtung erfolgt durch einen Aufbringaktuator 11, an dem über eine den Deckel 17 durchsetzende Aktuatorstange 19 der Düsenkörper 12 quer, also parallel zur Ebene E angebracht ist.

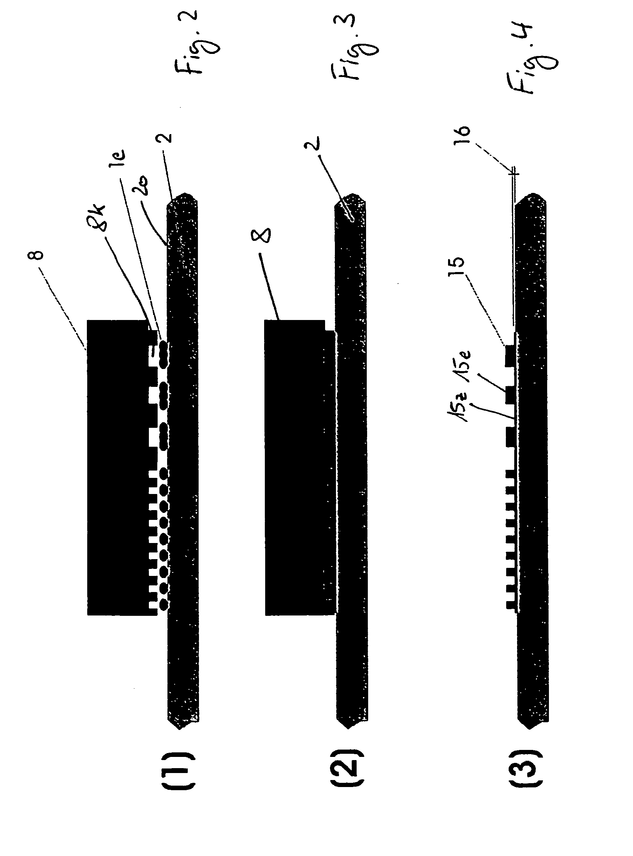

Durch die Düsen 12d wird Strukturmaterial 1 auf eine dem Düsenkörper 12 gegenüberliegende Oberseite 2o des Substrats 2 aufgetragen. Die Auftragung erfolgt im step-and-repeat-Verfahren, das heißt die Oberseite 2o wird in mehreren Schritten mit Strukturmaterial 1 beaufschlagt. Dabei werden definierte Strukturmaterialeinheiten 1e des Strukturmaterials 1 (siehe Figur 2) auf die Oberseite 2o des Substrats 2 aufgetragen und derart platziert, dass diese mit Kavitäten 8k eines Prägestempels 8 beim späteren Prägevorgang korrespondieren, also ausschließlich in Strukturbereichen aufgetragen werden, die später als erhabene Strukturen 15e ausgehärtet werden. Insofern ist es von Vorteil, wenn die einzelnen Aufbringschritte der Aufbringeinrichtung 21 mit den einzelnen Prägeschritten der Prägeeinrichtung 20 korrespondieren. Die Düsen 12d decken daher insbesondere genau einen mit der Prägefläche des Prägestempels 8 korrespondierenden Bereich des Substrats 2 oder ein Vielfaches dieses Bereichs ab.

Sobald die Oberseite 2o des Substrats 2 vollständig mit Strukturmaterial 1 beziehungsweise mit Strukturmaterialeinheiten 1e beaufschlagt ist, wird das Substrat 2 gegenüberliegend der Prägeeinrichtung 20 positioniert und gegenüber dem Prägestempel 8 justiert, um den in Figuren 2 und 3 dargestellten Prägevorgang durchzuführen.

Dieser wird ebenfalls im step-and-repeat-Verfahren ausgeführt und die Prägekraft des Prägestempels 8 wird über eine den Prägestempel 8 aufnehmende Stempelhalterung 23 und auf die Stempelhalterung 23 einwirkende Aktuatoren 10 auf das Strukturmaterial 1 und das Substrat 2 aufgebracht.

Mit der Steuereinrichtung verbundene Kraftmesszellen 9 messen die durch die Aktuatoren 10 aufgebrachte Kraft und/oder Position, wobei alle drei Aktuatoren 10 einzeln positionsgeregelt und/oder kraftgeregelt einsetzbar sind, so dass auch Randbereiche durch Verlagerung der Prägekraft in den Kontaktflächenmittelpunkt homogen geprägt werden können.

In der in Figur 3 dargestellten Position des Prägestempels 8 zu dem Substrat 2 wird der Aushärtevorgang, insbesondere durch UV-Belichtung des Strukturmaterials 1, bei dem es sich um Fotolack handelt, durch ein in dem Deckel 17 eingelassenes Fenster 14 ausgeführt.

Nach Abziehen des Prägestempels 8 durch die Aktuatoren 10 verbleibt das in Figur 4 gezeigte ausgehärtete Strukturmaterial 15 auf dem Substrat 2, bestehend aus erhabenen Strukturen 15e und einer Zwischenschicht 15z mit einer Zwischenschichtdicke 16. Die verbleibende Zwischenschichtdicke 16 wird durch Ätzprozesse nach vollständiger Prägung und Aushärtung des gesamten Substrats 2 entfernt, um das Substrat 2 zu strukturieren. Die erhabenen Strukturen 15e dienen dabei als Ätzmaske.

Für das Substrat 2 als zu strukturierendes Substrat kommen runde oder rechteckige Substrate, beispielsweise Halbleiterwafer, Glaswafer, Keramiksubstrat oder Polymersubstrat in Frage.

Der Substrathalter 3 kann beispielsweise als Adhäsionshalterung oder elektrostatische Halterung ausgestaltet sein.

Der Prägestempel 8 kann als rechteckiger oder runder Stempel zum Stempeln oder Prägen der Strukturen, beispielsweise durch Hot Embossing oder UV-Prägen oder Micro Contact Printing ausgestaltet sein.

Dieser kann aber auch zumindest teilweise aus Quartz, Glas und/oder Hybridstrukturen bestehen und aus einem Träger, einer Ausgleichsschicht sowie einer Strukturschicht oder einem Träger und einer elastischen Strukturschicht gebildet sein.

Die Aushärtung des Strukturmaterials 1 erfolgt je nach Strukturmaterial, bei Lack beispielsweise durch UV-Licht oder IR-Licht.

Die Düsen 12d sind derart gestaltet, dass die als Tropfen aufgebrachten Strukturmaterialeinheiten 1e vom Volumen genau bemessen werden, um mit dem Volumen der Kavitäten 8k des Prägestempels 8 zu korrespondieren, wobei die Tropfendichte und das Tropfenvolumen gemäß dem aufzufüllenden Volumen der Kavitäten 8k so bemessen werden, dass eine möglichst geringe Zwischenschichtdicke 16 verbleibt. Das Tropfenvolumen kann mit Vorteil konstant eingestellt werden und bei größeren Kavitäten 8k werden dann mehrere Tropfen pro Kavität 8k aufgebracht. Das konstante Tropfenvolumen der Substratmaterialeinheiten 1e kann dabei mit der kleinsten Kavität 8k korrespondieren, während für größere Kavitäten 8k eine Vielzahl der Substratmaterialeinheiten 1e aufgebracht wird.

Das ausgehärtete Strukturmaterial 15 kann direkt als funktionelle Schicht wirken, aber auch - wie oben beschrieben - als Ätzmaske für den Strukturübertrag in das Substrat.

### Bezugszeichenliste

- 1: Strukturmaterial
- 1e: Strukturmaterialeinheit
- 2: Substrat
- 2o: Oberseite
- 3: Substrathalter
- 4: Justiertisch (X-, Y-Richtung und Rotation)
- 5: Justiergrundplatte
- 6: Grundplatte
- 7: Seitenwände
- 8: Prägestempel
- 8k: Kavitäten
- 9: Kraftmesszellen
- 10: Aktuatoren
- 11: Aufbringaktuator
- 12: Düsenkörper
- 12d: Düsen
- 13: Arbeitsraum
- 14: Fenster
- 15: ausgehärtetes Strukturmaterial
- 15e: erhabene Struktur
- 15z: Zwischenschicht
- 16: Zwischenschichtdicke
- 17: Deckel
- 18: Boden
- 19: Aktuatorstange
- 20: Prägeeinrichtung
- 21: Aufbringeinrichtung
- 22: Justiereinrichtung
- 23: Stempelhalterung
- 24: Aufnahmeeinrichtung

## Patentansprüche

1. Vorrichtung zum Prägen von Substraten (2), insbesondere Halbleitersubstraten oder Wafern, mit:
- mindestens einer Aufnahmeeinrichtung (24) zur Aufnahme des Substrats (2) in einem Arbeitsraum (13),
- einer zumindest teilweise im Arbeitsraum (13) angeordneten Justiereinrichtung (22) zur Justierung des Substrats (2),
- einer zumindest teilweise im Arbeitsraum (13) angeordneten Prägeeinrichtung (20) zum Prägen des Strukturmaterials (1) auf das Substrat (2) in einem Prägevorgang, wobei die Vorrichtung so ausgebildet ist, dass der Arbeitsraum (13) vor und während des Prägevorgangs, insbesondere ununterbrochen, mit einer definierten Atmosphäre beaufschlagbar ist, **dadurch gekennzeichnet, dass** eine zumindest teilweise im Arbeitsraum (13) angeordnete Aufbringeinrichtung (21) zur Aufbringung von Strukturmaterial (1) auf das Substrat (2) in einem Aufbringvorgang vorgesehen ist.

2. Vorrichtung nach Anspruch 1, bei der die definierte Atmosphäre einen Gasdruck kleiner dem Gasdruck außerhalb des Arbeitsraumes (13) aufweist, und die insbesondere quasi frei von Gasen, vorzugsweise frei von Luft, noch bevorzugter O2-frei, ist, vorzugsweise in Form eines Vakuums.

3. Vorrichtung nach mindestens einem der vorhergehenden Ansprüche, bei der der Arbeitsraum (13) über eine den Arbeitsraum (13) mit einer Druckbeaufschlagungseinrichtung, insbesondere einer Vakuumeinrichtung, verbindenden Druckleitung, insbesondere Vakuumleitung, mittels der Druckbeaufschlagungseinrichtung mit einem Druck oder Druckprofil als definierter Atmosphäre beaufschlagbar ist.

4. Vorrichtung nach mindestens einem der vorhergehenden Ansprüche, die als step-and-repeat-Vorrichtung zur Prägung des Substrats (2) in mehreren Prägeschritten innerhalb des Prägevorgangs ausgebildet ist.

5. Vorrichtung nach mindestens einem der vorhergehenden Ansprüche, bei der die Prägeeinrichtung (20) einen Prägestempel (8) aufweist mit auf das Substrat (2) zu prägenden Prägestrukturen, wobei die Prägestrukturen als Nanostrukturen oder kleiner als Nanostrukturen ausgebildet sind.

6. Vorrichtung nach mindestens einem der vorhergehenden Ansprüche, bei der der Aufbringvorgang in mehrere Aufbringschritte zur Aufbringung des Strukturmaterials (1) auf Flächenabschnitte des Substrats (2) unterteilt ist.

7. Vorrichtung nach Anspruch 6, bei der die Aufbringeinrichtung (21) Düsen (12d) zur Aufbringung des Strukturmaterials (1) in Tropfenform aufweist.

8. Vorrichtung nach mindestens einem der vorhergehenden Ansprüche, bei der die Aufbringeinrichtung (21) Mittel zur Aufbringung des Strukturmaterials (1) im Spinverfahren oder Siebdruckverfahren oder Sprühverfahren oder Piezoverfahren aufweist.

9. Vorrichtung nach mindestens einem der vorhergehenden Ansprüche, bei der der Aufbringvorgang zumindest teilweise in der definierten Atmosphäre, insbesondere nach Anspruch 2, durchführbar ist.

10. Vorrichtung nach mindestens einem der vorhergehenden Ansprüche, bei der der Aufbringvorgang so steuerbar ist, dass Strukturmaterial (1) nur in mit Kavitäten (8k) des Prägestempels (8) korrespondierenden Strukturbereichen in definierten Strukturmaterialeinheiten (1e) aufgebracht wird.

11. Vorrichtung nach Anspruch 10, bei der die Strukturmaterialeinheiten (1e) ein geringfügig größeres, insbesondere bis 10 %, bevorzugt bis 5 % größeres, Volumen als die korrespondierenden Kavitäten (8k) des Prägestempels aufweisen.

12. Verfahren zum Prägen von Substraten (2), insbesondere Halbleitersubstraten oder Wafern, mit folgenden Schritten:
a) Justierung des Substrats (2) mittels einer Justiereinrichtung gegenüber einer Aufbringeinrichtung (21) zur Aufbringung von Strukturmaterial (1) auf das Substrat (2) in einem Aufbringvorgang,
b) Aufbringung des Strukturmaterials oder von Strukturmaterialeinheiten des Strukturmaterials auf das Substrat (2) mittels der in Anspruch 1 beschriebenen Aufbringeinrichtung (21),
c) Justierung des Substrats (2) mittels einer zumindest teilweise im Arbeitsraum (13) angeordneten Justiereinrichtung (22) gegenüber einer zumindest teilweise im Arbeitsraum (13) angeordneten Prägeeinrichtung (20) zum Prägen des Strukturmaterials (1) auf das Substrat (2) in einem Prägevorgang und
d) Prägen des Substrats (2) durch die Prägeeinrichtung (20), wobei der Arbeitsraum (13) vor und während des Prägevorgangs ununterbrochen mit einer definierten Atmosphäre beaufschlagt ist.

13. Verfahren nach Anspruch 12, bei dem die definierte Atmosphäre einen Gasdruck kleiner dem Gasdruck außerhalb des Arbeitsraumes (13) aufweist, und die insbesondere quasi frei von Gasen, vorzugsweise frei von Luft, noch bevorzugter 02-frei, ist, vorzugsweise in Form eines Vakuums.

14. Verfahren nach Anspruch 12 oder 13, bei dem Schritt b) in der definierten Atmosphäre erfolgt, insbesondere mittels pneumatischen oder thermischen Verfahren oder Piezo- oder Siebdruck- oder Sprüh- oder Spinverfahren.

15. Verfahren nach mindestens einem der Ansprüche 12 bis 14, bei dem der Aufbringvorgang gemäß Schritt b) so steuerbar ist, dass Strukturmaterial (1) nur in mit Kavitäten (8k) des Prägestempels (8) korrespondierenden Strukturbereichen in definierten Strukturmaterialeinheiten (1e), die insbesondere ein geringfügig größeres, insbesondere 10 % größeres, Volumen als die korrespondierenden Kavitäten (8k) des Prägestempels (8) aufweisen, aufgebracht wird.

## Claims

1. Device for embossing of substrates (2), especially semiconductor substrates or wafers, with:
- at least one receiving means (24) for holding the substrate (2) in a working space (13),
- a calibration means (22) located at least partially in the working space (13) for calibration of the substrate (2),
- an embossing means (20) which is located at least partially in the working space (13) for embossing of the structure material (1) onto the substrate (2) in an embossing process, wherein the device is designed that the working space (13) being exposed to a defined atmosphere before and during the embossing process, especially without interruption, **characterized in that** an application means (21) is provided which is located at least partially in the working space (13) for application of structure material (1) to the substrate (2) in an application process.

2. Device as claimed in claim 1, wherein the defined atmosphere has a gas pressure less than the gas pressure outside the working space (13), and it is especially more or less free of gases, preferably free of air, even more preferably free of 02, preferably in the form of a vacuum.

3. Device as claimed in at least one of the preceding claims, wherein the working space (13) can be exposed to a pressure or a pressure profile as a defined atmosphere by a pressurization means, by way of a pressure line, especially a vacuum line, which connects the working space (13) to a pressurizing means, especially a vacuum means.

4. Device as claimed in at least one of the preceding claims, which is made as a step-and-repeat device for embossing the substrate (2) in several embossing steps within the embossing process.

5. Device as claimed in at least one of the preceding claims, wherein the embossing means (20) has an embossing die (8) with embossing structures which are to be embossed onto the substrate (2), the embossing structures being made as nanostructures or smaller than nanostructures.

6. Device as claimed in claim 5, wherein the application process is divided into several application steps for application of the structure material (1) to surface sections of the substrate (2).

7. Device as claimed in claim 6, wherein the application means (21) has nozzles (12d) for application of the structure material (1) in droplet form.

8. Device as claimed in at least one of the preceding claims, wherein the application means (21) has means for application of the structure material (1) in a spin method or screen printing method or spray method or piezo method.

9. Device as claimed in at least one of the preceding claims, wherein the application process can be carried out at least partially in a defmed atmosphere, especially as claimed in claim 2.

10. Device as claimed in at least one of the preceding claims, wherein the application process can be controlled such that the structure material (1) is applied only in structure regions which correspond to cavities (8k) of the embossing die (8) in defined structure material units (1e).

11. Device as claimed in claim 10, wherein the structure material units (1e) have a slightly larger volume, especially one which is larger by up to 10%, preferably up to 5%, than the corresponding cavities (8k) of the embossing die.

12. Method for embossing of substrates (2), especially semiconductor substrates or wafers, with the following steps:
a) Calibration of the substrate (2) by a calibration means relative to an application means (21) for applying structure material (1) to the substrate (2) in an application process,
b) application of the structure material or of structure material units of the structure material to the substrate (2) by the application means (21),
c) calibration of the substrate (2) by a calibration means (22) which is located at least partially in the working space (13) relative to an embossing means (20) which is located at least partially in the working space (13) for embossing the structure material (1) onto the substrate (2) in an embossing process and
d) embossing of the substrate (2) by the embossing means (20), and the working space (13) before and during the embossing process can be supplied especially without interruption with a defined atmosphere.

13. Method as claimed in claim 12, wherein the defined atmosphere has a gas pressure less than the gas pressure outside the working space (13), and it is especially more or less free of gases, preferably free of air, even more preferably free of 02, preferably in the form of a vacuum.

14. Method as claimed in claim 12 or 13, wherein step b) takes place in a defined atmosphere, especially by means of pneumatic or thermal methods or piezo or screen printing or spray or spin methods.

15. Method as claimed in at least one of claims 12 to 14, wherein the application process according to step b) can be controlled such that the structure material (1) is applied only in structure regions which correspond to cavities (8k) of the embossing die (8) in defined structure material units (1e) which have especially a slightly larger, especially 10% larger, volume than the corresponding cavities (8k) of the embossing die (8).

## Revendications

1. Dispositif pour estamper des substrats (2), en particulier des substrats de semi-conducteurs ou des tranches, comprenant :
- au moins un dispositif de réception (24) pour recevoir le substrat (2) dans un espace de travail (13),
- un dispositif d'ajustage (22) disposé au moins partiellement dans l'espace de travail (13) pour ajuster le substrat (2),
- un dispositif d'estampage (22) disposé au moins partiellement dans l'espace de travail (13) pour estamper le matériau de structure (1) sur le substrat (2) au cours d'une procédure d'estampage, sachant que le dispositif est ainsi conçu que l'espace de travail (13), avant et pendant la procédure d'estampage, peut être alimenté en particulier de manière ininterrompue avec une atmosphère définie, **caractérisé en ce qu'**un dispositif d'application (21) disposé au moins partiellement dans l'espace de travail (13) est prévu pour appliquer du matériau de structure (1) sur le substrat (2) au cours d'une procédure d'application.

2. Dispositif selon la revendication 1, dans lequel l'atmosphère définie présente une pression de gaz inférieure à la pression de gaz hors de l'espace de travail (13) et est quasiment exempte de gaz, est de préférence exempte d'air, est de manière plus préférée exempte d'O2, est de préférence sous la forme d'un vide.

3. Dispositif selon au moins l'une des revendications précédentes, dans lequel l'espace de travail (13), via une conduite de pression, en particulier une conduite de vide, reliant l'espace de travail (13) à un dispositif d'alimentation en pression, en particulier à un dispositif de vide, peut être alimenté en pression ou en profilé de pression en tant qu'atmosphère définie, au moyen du dispositif d'alimentation en pression.

4. Dispositif selon au moins l'une des revendications précédentes, conçu en tant que dispositif step-and-repeat pour estamper le substrat (2) en plusieurs étapes d'estampage au cours de la procédure d'estampage.

5. Dispositif selon au moins l'une des revendications précédentes, dans lequel le dispositif d'estampage (20) présente un poinçon d'estampage (8) avec des structures d'estampage à estamper sur le substrat (2), sachant que les structures d'estampage sont formées en tant que nanostructures ou sont inférieures à des nanostructures.

6. Dispositif selon au moins l'une des revendications précédentes, dans lequel la procédure d'application est divisée en plusieurs étapes d'application pour appliquer le matériau de structure (1) sur des sections de surface du substrat (2).

7. Dispositif selon la revendication 6, dans lequel le dispositif d'application (21) présente des buses (12d) pour appliquer le matériau de structure (1) sous forme de gouttes.

8. Dispositif selon au moins l'une des revendications précédentes, dans lequel le dispositif d'application (21) présente des moyens pour appliquer le matériau de structure (1) par un procédé de filage ou sérigraphie ou pulvérisation ou piézo.

9. Dispositif selon au moins l'une des revendications précédentes, dans lequel la procédure d'application peut être effectuée au moins partiellement dans l'atmosphère définie, en particulier selon la revendication 2.

10. Dispositif selon au moins l'une des revendications précédentes, dans lequel la procédure d'application peut être commandée de sorte que le matériau de structure (1) ne peut être appliqué que dans des zones de structure dans des unités de matériau de structure définies (1e), correspondant à des cavités (8k) du poinçon d'estampage (8).

11. Dispositif selon la revendication 10, dans lequel les unités de matériau de structure (1e) présentent un volume légèrement plus grand, en particulier jusqu'à 10%, de préférence plus grand jusqu'à' 5% que les cavités (8k) correspondantes du poinçon d'estampage (8).

12. Procédé pour estamper des substrats (2), en particulier des substrats de semi-conducteurs ou des tranches, comprenant les étapes suivantes :
a) ajustage du substrat (2) au moyen d'un dispositif d'ajustage par rapport à un dispositif d'application (21) pour appliquer du matériau de structure (1) sur le substrat (2) au cours d'une procédure d'application,
b) application du matériau de structure ou d'unités de matériau de structure du matériau de structure sur le substrat (2) au moyen du dispositif d'application (21) décrit dans la revendication 1,
c) ajustage du substrat (2) au moyen d'un dispositif d'ajustage (22) disposé au moins partiellement dans l'espace de travail (13) par rapport à un dispositif d'estampage (20) disposé au moins partiellement dans l'espace de travail (13) pour estamper le matériau de structure (1) sur le substrat (2) au cours d'une procédure d'estampage et
d) estampage du substrat (2) par le dispositif d'estampage (20), dans lequel l'espace de travail (13), avant et pendant la procédure d'estampage, est alimenté de manière ininterrompue avec une atmosphère définie.

13. Procédé selon la revendication 12, dans lequel l'atmosphère définie présente une pression de gaz inférieure à la pression de gaz hors de l'espace de travail (13) et est quasiment exempte de gaz, est de préférence exempte d'air, est de manière plus préférée exempte d'O2, est de préférence sous la forme d'un vide.

14. Procédé selon la revendication 12 ou 13, dans lequel l'étape b) a lieu dans l'atmosphère définie, en particulier via un procédé pneumatique ou thermique ou bien via un procédé de filage ou sérigraphie ou pulvérisation ou piézo.

15. Procédé selon au moins l'une des revendications 12 à 14, dans lequel la procédure d'application selon l'étape b) peut être ainsi commandée que le matériau de structure (1) ne peut être appliqué que dans des zones de structure dans des unités de matériau de structure définies (1e), correspondant à des cavités (8k) du poinçon d'estampage (8), qui présentent en particulier un volume légèrement plus grand, en particulier de 10%, que les cavités (8k) correspondantes du poinçon d'estampage (8).
